# EUROPEAN PATENT APPLICATION

(11) **EP 4 564 675 A1**
(43) Date of publication of application: **04.06.2025**
(21) Application number: 23213100.3
(22) Date of filing: 29.11.2023
(51) Int. Cl.: H03K 17/12, H03K 17/13, H02M 1/088

(54) **PARALLELING SEMICONDUCTOR SWITCH DEVICES, ESPECIALLY IN AN AIRCRAFT**

(71) Applicant: Airbus S.A.S., 31700 Blagnac (FR)
(72) Inventor: KAPAUN, Florian, 82024 Taufkirchen (DE); GALEK, Marek, 80335 München (DE)
(74) Representative: OTN Airbus SAS

(57) **Abstract**

For enabling paralleling a low number of semiconductors or modules, especially for aircraft applications, in a simplified, reliable way with minimal additional effort, the invention provides an operation method for a semiconductor switch arrangement (18) comprising a first semiconductor switch device (32.1) and a second semiconductor switch device (32.2) connected in parallel to each other between common nodes (N1, N2), the method comprising alternatively conducting a first switching period (SP1) and a second switching period (SP2), wherein the first switching period (SP1) comprises turning on the first switching device (32.1) to take the whole current (I_{L}) between the common nodes (N1, N2) first and then turning on the second switching device (32.2) at zero voltage between the common nodes (N1, N2), and wherein the second switching period (SP2) comprises turning on the second switching device (32.2) to take the whole current (I_{L}) between the common nodes first and then turning on the first switching device (32.1) at zero voltage between the common nodes (N1, N2).

## Description

The invention relates to an operation method for a semiconductor switch arrangement comprising a first semiconductor switch device and a second semiconductor switch device connected in parallel to each other between common nodes, especially on an aircraft. Further, the invention provides to a semiconductor switch arrangement comprising a first semiconductor switch device and a second semiconductor switch device connected in parallel to each other between common nodes configured to be controlled in accordance with the operation method. Further, the invention provides an aircraft with such a semiconductor switch arrangement.

For technical background, reference is made to the following literatures:
[1] "Paralleling Power MOSFETs for Switching Applications", Semiconductor Components Industries, LLC, 2021, May, 2021 - Rev. 0,1 Publication Order Number: AND90108/D, download on 15.11.2023 under https://www.onsemi.com/pub/collateral/and90108-d.pdf
[2] "Paralleling power MOSFETs in high current applications -Effect of MOSFET parameter mismatch on current and power dissipation imbalance", Edition 2021-05-14, AN_2009_PL18_2010_105641, Published by Infineon Technologies AG
[3] Wikipedia "Power electronics" - download on 15.11.2023 from https://en.wikipedia.org/wiki/Power_electronics
[4] "Hybrid and electric flight" - Airbus, download on 15.11.2023 from https://www.airbus.com/en/innovation/low-carbon-aviation/hybrid-and-electric-flight
[5] Wikipedia - "Electric Aircraft" - download on 15.11.2023 from https://en.wikipedia.org/wiki/Electric_aircraft

The invention relates to the field of power electronics, especially for aircraft, more preferably for electric aircrafts as referred to in [4] and [5]. More specifically, the invention relates to power electronics and optimized inverters, especially for an aircraft.

Especially, the invention relates to semiconductor switch arrangements such as power switches, inverters, converters using paralleled semiconductor power switch devices such as power transistors, especially field-effect transistors (FETs), MOSFETS or IGBTs.

Paralleling of semiconductor switch devices such as MOSFETs refers to the process of connecting multiple semiconductor switch devices such as MOSFETs in parallel to increase the overall current handling capacity of the circuit. This technique is commonly used in power electronics circuits - see [1] and [2] - to achieve high power output. When paralleling MOSFETs, it is important to ensure that each MOSFET is sharing the load equally to avoid any imbalance in current flow. One of the challenges of paralleling MOSFETs is ensuring that the MOSFETs share the current equally, especially in high-power applications. Advanced control techniques such as current sharing algorithms and dynamic load balancing have been developed to achieve this goal. These techniques use feedback control to adjust the gate voltage of each MOSFET to ensure that they share the current equally. These methods come with higher complexity and additional implementation effort. In state-of-the-art applications, paralleling of FETs is often done by creation of symmetrical layouts and using pre-selected components.

An object of the invention is to enable paralleling a low number of semiconductors or modules, especially for aircraft applications, in a simplified, reliable way with minimal additional effort.

For achieving such object, the invention provides the method and the arrangement of the enclosed independent claims.

Advantageous embodiments are subject-matters of the dependent claims.

The invention provides according to a one aspect thereof an operation method for a semiconductor switch arrangement comprising a first semiconductor switch device and a second semiconductor switch device connected in parallel to each other between common nodes, the method comprising alternatively conducting a first switching period and a second switching period,
wherein the first switching period comprises turning on the first switching device to take the whole current between the common nodes first and then turning on the second switching device at zero voltage between the common nodes, and wherein the second switching period comprises turning on the second switching device to take the whole current between the common nodes first and then turning on the first switching device at zero voltage between the common nodes.

Preferably, the first switching period further comprises turning off the second switching device first at zero voltage between the common nodes so that the first switching device takes the whole current between the common nodes and then turning off the first switching device and the second switching period further comprises turning off the first switching device first at zero voltage between the common nodes so that the second switching device takes the whole current between the common nodes and then turning off the second switching device.

In some embodiments, the operation method is an operation method for operating a semiconductor switch arrangement comprising n semiconductor switch devices connected in parallel to each other between common nodes wherein n is a natural number with n>2, comprising alternatively conducting n switching periods wherein in each switching periods another of the n switching devices is turned on first to take the whole current between the common nodes and then the other of the n switching devices are turned on at zero voltage between the common nodes.

In some embodiments, the timing between the turning on of the first and second switching devices - the first before the second or the second before the first - is chosen, adjusted or controlled dependent from additional measured data, especially including device temperature or power loss.

In some embodiments, the semiconductor switch arrangement is one of the group consisting of a power switch, a power electronic, an inverter, a DC/DC converter, an AC/DC converter, a semiconductor switch arrangement for an aircraft, a semiconductor switch arrangement for an electrical power train of an aircraft, a power switch for an aircraft, a power electronic for an aircraft, an inverter for an aircraft, a DC/DC converter for an aircraft, an AC/DC converter for an aircraft.

In some embodiments, each switching device is one from the group consisting of a power transistor, a field-effect-transistor, a MOSFET, an IGBT, and a semiconductor power switching module. All switching devices are of the same kind, e.g., a first and second MOSFET, or a first and second IGBT or a first and second module of equal design.

Preferably, the operation method is conducted on an aircraft for providing an electrical consumer of the aircraft with electrical power. Especially, the method is an operation method for an inverter of an aircraft, such as a motor inverter for powering an electric motor of the aircraft, e.g., for propulsion.

According to another aspect, the invention provides a semiconductor switch arrangement, especially for an aircraft, comprising:
a first semiconductor switch device and a second semiconductor switch device connected in parallel to each other between common nodes, and
a control means adapted to execute the steps of the operation method of any of the aforementioned embodiments.

Preferably, the semiconductor switch arrangement is chosen from the group consisting of a power switch, a power electronic, an inverter, a DC/DC converter, an AC/DC converter, a semiconductor switch arrangement for an aircraft, a semiconductor switch arrangement for an electrical power train of an aircraft, a power switch for an aircraft, a power electronic for an aircraft, an inverter for an aircraft, a DC/DC converter for an aircraft, an AC/DC converter for an aircraft.

Preferably, each switching device is chosen from the group consisting of a power transistor, a field-effect-transistor, a MOSFET, an IGBT, and a semiconductor power switching module. The same type is chosen for all paralleled semiconductor switch devices.

According to another aspect, the invention provides a computer program comprising instructions to cause the semiconductor switch arrangement according to any of the aforementioned embodiments for the arrangement to execute the steps of the operation method of any of aforementioned embodiments for the operation method.

According to another aspect, the invention provides an aircraft comprising a semiconductor switch arrangement according to of the aforementioned embodiments and/or a computer readable medium or memory having stored thereon the computer program as mentioned before.

Preferred embodiments of the invention relate to paralleling of Mosfets or the like/ Modules by swapped switching control.

Preferred embodiments of the invention describe a method to parallel a low number of semiconductors or modules in a simplified, reliable way with minimal additional effort.

For an inverter using Power Mosfets, mainly switching losses and on-state losses determine the inverter behaviour and the achievable power ratings. Preferred embodiments of the invention mainly focuse on the switching losses.

As indicated in [1] and [2], when paralleling multiple semiconductors, it is up to now important that all devices exactly switch identically to share the losses equally. Unfortunately, semiconductors never behave the same (as e.g., the threshold voltage differs slightly between devices). This means one semiconductor switches earlier and therefore takes more losses. This leads to an unbalanced load sharing if no countermeasure is taken.

To overcome this, the invention proposes an inconvenient way of controlling the semiconductors during switching.

As equal switching never can be achieved by 100% (only when one single semiconductor is switching) preferred embodiments of the invention control the inverter or the like in a way where only one semiconductor switch is switching at each transition.

Assuming that more than one semiconductor switch is put in parallel, the switching one takes the complete current and therefore generates additional losses. Within the next period the second semiconductor switch (e.g., transistor) turns on earlier and therefore takes all the switching losses. The semiconductor switch turning on later always switches at zero voltage and therefore switches without any losses (zero voltage switching).

By swapping all paralleled semiconductor switches (e.g., transistors), an equal averaging can be achieved. Due to that mechanism, differences in switching behaviour are equalled out and losses across the paralleled switching devices (e.g., transistors; FETs, MOSFETs,) are averaged.

The efficiency of this method can even be increased by adjusting the timings when the dedicated semiconductors turn on or off.

Preferred embodiments of the invention offer a very simple method to control paralleled semiconductors or modules without the need of complex control algorithms. In case of additional available measurement data (e.g., device temperature) the proposed solution can be optimized by a smarter timing.

A smarter timing also allows to compensate for differences in the on-state behaviour as the current conduction time of the single devices can be controlled in a flexible manner.

If multiple (more than 2) devices are used it is implicitly foreseen that the active switching transistor can withstand the overall phase current of one single phase (only for a very short time).

Preferred embodiments of the invention have one, several or all of the following advantages:
- Due to the simplicity of the concept, the system works very reliable.
- Low control effort is necessary
- Preselection of components can be relaxed

Preferred uses of embodiments of the invention are power electronic systems for providing an aircraft component, especially a drive train, with electrical power. For example, embodiments of the invention are used in inverters for powering an electric motor with energy from a DC energy source such as a battery or a fuel cell.

Embodiments of the invention are explained below referring to the accompanying drawings in which:
- Fig. 1: is a schematic plan view of an embodiment of an aircraft with a semiconductor switching arrangement such as an inverter of an electric drive;
- Fig. 2: a simplified diagram of an embodiment of an inverter as example for the semiconductor switching arrangement with a plurality of semiconductor switch devices connected in parallel between common nodes;
- Fig. 3: a graph with timings of control voltages for the semiconductor switching devices and of voltages and currents between the common nodes for illustrating an operation method for the semiconductor switching arrangement.

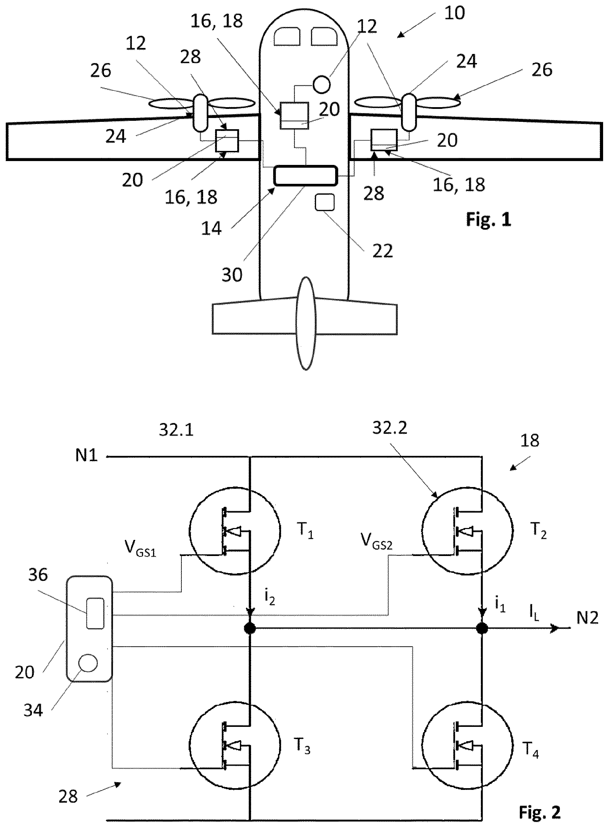

Fig. 1 shows an aircraft 10 having at least one electrical consumer 12, at least one energy source 14 and at least one power electronic 16 for supplying the electrical consumer 12 with electrical power from the energy source 14. The power electronic 16 includes a semiconductor switch arrangement 18 and a control 20.

The control 20 may be part of a component of the power electronic 16 or may be implemented as part of an outside control unit, e.g., in a computer unit 22 of the aircraft 10.

The electrical consumer 12 can be of any kind of aircraft component to be powered with AC or DC power such as an electrical actor, a motor pump, or an electric motor 24. For example, the motor 24 is a propulsion motor for driving a flight propulsion element such as a propeller 26 of the aircraft 10.

In some embodiments, the power electronic 16 or the semiconductor switch arrangement 18 is an inverter 28 for supplying the electrical consumer 12 with AC power converted from a DC energy source 14 such as a battery 30 or a fuel cell or a DC power network including several batteries and/or fuel cells (not shown). Other examples for the semiconductor switch arrangement 18 are DC/DC converters, AC/DC converters and power switches.

Fig. 2 shows a simplified schematic diagram of an embodiment of the inverter 28 as an example for the power electronic 16 with the semiconductor switch arrangement 18. As shown in the example of Fig. 2, the semiconductor switch arrangement 18 includes a first semiconductor switch device 32.1 and a second semiconductor switch device 32.2 connected in parallel to each other between common nodes N1 and N2.

In some embodiments, the semiconductor switch devices 32.1, 32.2 are semiconductor power switches, especially single semiconductor power transistors such as field-effect transistors (FET), Mosfets or IGBTs. In other embodiments (not shown), the semiconductor devices 32.1, 32.2 are modules including an arrangement of semiconductors to function as a power switch. In the embodiment shown, the first and second semiconductor devices 32.1, 32.2 are MOSFETS. Especially, the inverter 28 includes a first to fourth transistor T1-T4 wherein two of them are connected in parallel to each other.

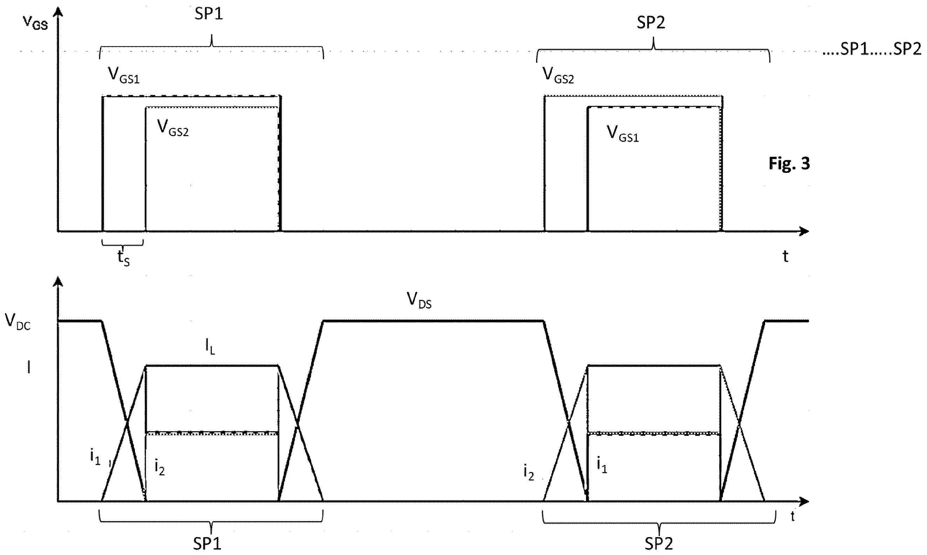

Referring to Figs. 2 and 3, an operation method for the semiconductor switch arrangement 18 enabling a paralleling of the semiconductor switch devices 32.1, 32.2 is explained in the following on basis of the first and second transistors T₁, T₂ which are connected in parallel between the nodes N1 (e.g., power input for the first half of the inverter 28) and N2 (e.g., power output for outputting a load current I_{L} to the load, e.g., one phase of the motor 24). The transistors T₁, T₂ are Mosfets with Source, Drain and Gate. V_{GS1} designates the gate source voltage between gate and source of the first transistor T₁ (example for the first semiconductor switch device 32.1), V_{GS2} designates the gate-source voltage between gate and source of the second transistor T₂ (example for the second semiconductor switch device 32.2). i₁ represents the current through the first transistor T₁, i₂ represents the current through the second transistor T₂, and I_{L} represents the load current.

Fig. 3 is a graph showing the course of the gate-source voltages V_{GS}, V_{GS1}, V_{GS2} for the first and second transistors T₁, T₂ and the course of the DC-link voltage V_{DS} between drain and source, which corresponds to the voltage between the common nodes N1, N2, and of the currents I, i₁, i₂ and I_{L} over the time t. I_{L} corresponds to the current I between the common nodes N1, N2. The gate source voltage V_{GS1} and the current i₁ for the first transistor T₁ is shown in broken lines, while the gate source voltage V_{GS2} and the current i₂ for the second transistor T₂ is shown in dotted lines.

The control 20 may include a processor 34 and a computer readable medium, especially a memory 36, with a computer program containing instructions to carry out the following operation. The control routine may be part of a control for controlling the inverter 28 during different operation modes for driving the motor 24 or any other consumer 12.

The control 20 controls the inverter 28 in the following way. For simplification only one phase with two paralleled switches - e.g., transistors T1, T2 - is shown.

In a first switching period SP1, at the beginning the first transistor T₁ is turned on and takes the full current I_{L}.

When the current commutation is done (V_{DS} = 0V), T₂ also turns on. This leads to the situation that the load current I_{L} is equally shared between the first and second transistors T₁ andT₂.

The second transistor T₂ is turned off a little bit earlier. Thus, the second transistor T₂ turns off at zero Voltage so that it has no losses. During this short time, the first transistor T₁ takes again the complete current and turns off.

In the next period - second switching period SP2 -, the procedure is repeated but with the second transistor T₂ turning on earlier and off later.

After that the first period SP1 is conducted again.

In some embodiments, the time ts between turning on the one of the first and second transistors T1, T2 and then turning on the other of the first and second transistors T1, T2, is adjusted depending on measured parameters such as the temperature of the semiconductor switching device 32.1, 32.2.

Thus, some embodiments comprise the steps of measuring at least one parameter indicative of a load or a loss in the first and/or second semiconductor switch 32.1, 32.2 (especially a device temperature) and adjusting, adapting or controlling the timing ts for turning the first and second semiconductor switch 32.1, 32.2 on and off depending on the at least one measured parameter.

In further embodiments (not shown), n transistors T₁, Tₛ..., Tₙ are connected in parallel between the common nodes N1, N2 for sharing the load. In this case n switching periods SPn are conducted alternatively wherein in each of the n switching periods another one of the n transistors Tn is turned on first and turned off later while the other transistors are switched at zero Voltage.

By swapping all paralleled semiconductor switches 32.1, 32.2, 32.n (e.g., transistors T₁, T₂, Tₙ), an equal averaging can be achieved. Due to that mechanism, differences in switching behaviour are equalled out and losses across the paralleled switching devices 32.1, 32.2 are averaged.

For enabling paralleling a low number of semiconductors or modules, especially for aircraft applications, in a simplified, reliable way with minimal additional effort, the invention provides an operation method for a semiconductor switch arrangement (18), especially of an aircraft (10) comprising a first semiconductor switch device (32.1) and a second semiconductor switch device (32.2) connected in parallel to each other between common nodes (N1, N2), the method comprising alternatively conducting a first switching period (SP1) and a second switching period (SP2), wherein the first switching period (SP1) comprises turning on the first switching device (32.1) to take the whole current (I_{L}) between the common nodes (N1, N2) first and then turning on the second switching device (32.2) at zero voltage between the common nodes (N1, N2), and wherein the second switching period (SP2) comprises turning on the second switching device (32.2) to take the whole current (I_{L}) between the common nodes first and then turning on the first switching device (32.1) at zero voltage between the common nodes (N1, N2).

Further, a semiconductor switch arrangement (18) for an aircraft (10) has been described, comprising:
a first semiconductor switch device (32.1) and a second semiconductor switch device (32.2) connected in parallel to each other between common nodes (N1, N2), and a control means (20) adapted to execute the steps of the aforementioned operation method.

### Reference sign list:

- 10: aircraft
- 12: electrical consumer
- 14: energy source
- 16: power electronic
- 18: semiconductor switch arrangement
- 20: control
- 22: computer unit
- 24: motor
- 26: propeller
- 28: inverter
- 30: battery
- 32.1: first semiconductor switch
- 32.2: second semiconductor switch
- 34: processor
- 36: memory
- i₁: source drain current through first transistor
- i₂: source drain current through second transistor
- I_{L}: load current
- N1: first node
- N2: second node
- T₁: first transistor (example for first semiconductor switching device)
- T₂: second transistor (example for second semiconductor device)
- T₃: third transistor
- T₄: fourth transistor
- V_{DC}: DC link voltage
- V_{DS}: drain source voltage (voltage between common nodes)
- V_{GS1}: gate source voltage (first transistor)
- V_{GS2}: gate source voltage (second transistor)

## Claims

1. Operation method for a semiconductor switch arrangement (18) comprising a first semiconductor switch device (32.1) and a second semiconductor switch device (32.2) connected in parallel to each other between common nodes (N1, N2), the method comprising alternatively conducting a first switching period (SP1) and a second switching period (SP2),
wherein the first switching period (SP1) comprises turning on the first switching device (32.1) to take the whole current (I_{L}) between the common nodes (N1, N2) first and then turning on the second switching device (32.2) at zero voltage between the common nodes (N1, N2), and
wherein the second switching period (SP2) comprises turning on the second switching device (32.2) to take the whole current (I_{L}) between the common nodes first and then turning on the first switching device (32.1) at zero voltage between the common nodes (N1, N2).

2. Operation method according to claim 1 wherein
the first switching period (SP1) further comprises turning off the second switching device (32.2) first at zero voltage between the common nodes (N1, N2) so that the first semiconductor switching device (32.1) takes the whole current (I_{L}) between the common nodes (N1, N2) and then turning off the first switching device (32.1) and
the second switching period (SP2) further comprises turning off the first switching device (32.1) first at zero voltage between the common nodes (N1, N2) so that the second semiconductor switching device (32.2) takes the whole current (I_{L}) between the common nodes (N1, N2) and then turning off the second switching device (32.2).

3. Operation method according to any of the preceding claims for a semiconductor switch arrangement (18) comprising n semiconductor switch devices (32.1, 32.2,..) connected in parallel to each other between common nodes (N1, N2) wherein n is a natural number with n>2, comprising alternatively conducting n switching periods wherein in each of the n switching period another of the n semiconductor switching devices is turned on first to take the whole current (I_{L}) between the common nodes (N1, N2) and then the other of the n semiconductor switching devices are turned on at zero voltage between the common nodes (N1, N2).

4. Operation method according to any of the preceding claims wherein the timing (ts) between the turning on of the first and second switching devices (32.1, 32.2) is chosen, adjusted or controlled dependent from additional measured data, especially including device temperature or power loss.

5. Operation method according to any of the preceding claims wherein
5.1 the semiconductor switch arrangement (18) is one of the group consisting of a power switch, a power electronic (16), an inverter (28), a DC/DC converter, a AC/DC converter, a semiconductor switch arrangement (18) for an aircraft (10), a semiconductor switch arrangement (18) for an electrical power train of an aircraft (10), a power switch for an aircraft, a power electronic (16) for an aircraft (10), an inverter (28) for an aircraft (10), a DC/DC converter for an aircraft, a AC/DC converter for an aircraft; and/or
5.2 each semiconductor switching device is one from the group consisting of a power transistor (T₁-T₄), a field-effect-transistor, a MOSFET, an IGBT, and a semiconductor power switching module.

6. Operation method according to any of the preceding claims, wherein the operation method is conducted on an aircraft (10) for providing an electrical consumer (12) of the aircraft (10) with electrical power.

7. Semiconductor switch arrangement (18) comprising:
a first semiconductor switch device (32.1) and a second semiconductor switch device (32.2) connected in parallel to each other between common nodes (N1, N2), and
a control means (20) adapted to execute the steps of the operation method of any of the proceeding claims.

8. Semiconductor switch arrangement (18) according to claim 7, chosen from the group consisting of a power switch, a power electronic (16), an inverter (28), a DC/DC converter, a AC/DC converter, a semiconductor switch arrangement (18) for an aircraft (10), a semiconductor switch arrangement (18) for an electrical power train of an aircraft (10), a power switch for an aircraft, a power electronic (16) for an aircraft (10), an inverter (28) for an aircraft (10), a DC/DC converter for an aircraft (10), a AC/DC converter for an aircraft (10).

9. Semiconductor switch arrangement (18) according to any of the claims 7 and 8, wherein each semiconductor switching device (32.1, 32.2) is one from the group consisting of a power transistor (T₁-T₄), a field-effect-transistor, a MOSFET, an IGBT, and a semiconductor power switching module.

10. Computer program comprising instructions to cause the semiconductor switch arrangement (18) according to any of the claims 7 to 9 to execute the steps of the operation method of any of the claims 1 to 6.

11. Aircraft (10) comprising a semiconductor switch arrangement (18) according to any of the claims 7 to 9 and/or a computer readable medium or memory (36) having stored thereon the computer program of claim 10.
